# FASCICULE DE BREVET EUROPEEN

(11) **EP 2 920 811 B1**
(45) Date de publication et mention de la délivrance du brevet: **17.06.2020**
(21) Numéro de dépôt: 13801652.2
(22) Date de dépôt: 12.11.2013
(51) Int. Cl.: H01L 23/498, H01L 21/48, H01B 1/04

(54) **INTERPOSEUR EN GRAPHENE ET PROCEDE DE FABRICATION D'UN TEL INTERPOSEUR**
GRAPHENZWISCHENTRÄGER UND VERFAHREN ZUR HERSTELLUNG SOLCH EINES ZWISCHENTRÄGERS
GRAPHENE INTERPOSER AND METHOD OF MANUFACTURING SUCH AN INTERPOSER

(30) Priorité: 13.11.2012 FR 1260768
(43) Date de publication de la demande: 23.09.2015
(73) Titulaire: Commissariat à l'Énergie Atomique et aux Énergies Alternatives, 75015 Paris (FR)
(72) Inventeur: ALIANE, Abdelkader, F-38100 Grenoble (FR); CORONEL, Philippe, F-38530 Barraux (FR)
(74) Mandataire: Cabinet Laurent & Charras
(86) Numéro de dépôt international: PCT/FR2013/052712
(87) Numéro de publication internationale: WO 2014/076406

(56) Documents cités:
- WO-A1-2012/113898
- US-A1- 2004 195 669
- US-A1- 2008 277 776
- US-A1- 2011 108 854
- Duhee Yoon ET AL: "Negative Thermal Expansion Coefficient of Graphene Measured by Raman Spectroscopy", Nano Letters, vol. 11, no. 8, 5 July 2011 (2011-07-05), pages 3227-3231, XP055676879, US ISSN: 1530-6984, DOI: 10.1021/nl201488g

## Description

### DOMAINE DE L'INVENTION

L'invention a trait au domaine de l'intégration dite « tridimensionnelle », dans laquelle des circuits électroniques sont empilés les uns sur les autres au moyen de dispositif d'interface, ou « interposeur », réalisant une connexion électrique et mécanique entre les circuits.

### ETAT DE LA TECHNIQUE

Afin de gagner en surface de circuit et/ou pouvoir utiliser différentes technologies de fabrication dans un même dispositif électronique, il est connu d'empiler des circuits microélectroniques, ce type d'intégration étant communément désignée sous l'expression « micropackaging 3D ».

Usuellement, les circuits sont connectés électriquement et mécaniquement au moyen d'interposeurs comprenant une couche de silicium, -de verre ou de graphite, traversée de part en part par des électrodes métalliques en contact avec des plages ou des pistes électriques des circuits, permettant ainsi leur communication et/ou leur alimentation électrique. Dans l'état de la technique, il est recherché des interposeurs qui présentent la combinaison des caractéristiques suivantes pour la couche de support des électrodes: une bonne isolation électrique pour éviter de mettre en court-circuit les électrodes et/ou éviter des courants de fuite, une bonne conduction thermique pour dissiper la chaleur, et un coefficient d'expansion thermique positif le plus proche possible du coefficient d'expansion thermique des circuits connectés à l'interposeur, circuits qui sont usuellement composés de matériaux à coefficient d'expansion thermique positif, comme par exemple des matériaux semi-conducteurs et des métaux. Ces contraintes de conception sont par exemple décrites dans les US 2008/0277776 et US 2004/0195669.

Si un interposeur en silicium ou en verre est peu onéreux et a une bonne dispersion thermique, à mesure que le volume de silicium diminue suite à l'amincissement de l'interposeur, par exemple pour des raisons de miniaturisation, le volume du métal des connexions traversantes devient en proportion plus important, ce qui peut provoquer un échauffement important de l'interposeur. En outre, un interposeur en silicium présente une rigidité élevée qui rend son utilisation difficile dans certaines applications, par exemple dans le cadre de peaux électroniques. Enfin, les métaux constitutifs des connexions présentent un module de Young très élevé, ce qui fragilise la couche de silicium dans laquelle elles sont réalisées.

En outre, les électrodes métalliques traversantes sont réalisées en gravant des trous dans une couche de silicium ou de verre préalablement formée par une technique de dépôt, puis en remplissant ces trous d'un métal. Or, la formation de trous traversants ayant facteur de forme de bonne qualité, notamment des trous ayant une section constante sur toute l'épaisseur d'une couche de silicium ou de verre, nécessite l'utilisation de technologies de gravure complexes et couteuses.

Afin de pallier ces problèmes, il a été proposé la mise en œuvre d'un interposeur en matériau organique, notamment en matériau organochloré, tel que les polychlorobiphényles. En effet, les polychlorobiphényles ont l'avantage d'être souples et une couche en polychlorobiphényle munie de trous traversants réguliers peut être formée simplement en une seule étape à l'aide de techniques de fabrication à bas coût, notamment par sérigraphie.

Toutefois, les polychlorobiphényles sont de mauvais conducteurs thermiques et ne peuvent pas évacuer à eux seuls des flux thermiques importants, atteignant fréquemment des valeurs supérieures à 300W/cm², usuellement rencontrés dans les circuits microélectroniques. La chaleur s'accumule ainsi dans ce type d'interposeur, de sorte qu'un choc thermique apparait et endommage à la fois l'interposeur et les circuits auxquels il est connecté. En outre, les polychlorobiphényles ont une forte permittivité diélectrique pour les hautes fréquences, ce qui perturbe le fonctionnement des circuits opérant à hautes fréquences.

Par ailleurs, quel que soit le type d'interposeur de l'état de la technique, on constate généralement une grande différence entre le coefficient d'expansion thermique, positif, de la couche dans laquelle sont formées les électrodes, et le coefficient d'expansion thermique, positif, du métal utilisé pour les électrodes. Soumis à de fortes variations thermiques, les différentes parties de l'interposeur se dilatent ou se contractent donc différemment, fragilisant ainsi l'ensemble.

Enfin, les circuits connectés au travers d'un interposeur subissent également des contractions ou des dilatations différentes, notamment parce qu'ils présentent des coefficients d'expansion différents, et/ou parce qu'ils sont sujets à des variations de température différentes, ce qui là encore fragilise l'ensemble.

### EXPOSE DE L'INVENTION

Le but de la présente invention est de proposer un interposeur, destiné à connecter électriquement et mécaniquement des circuits microélectroniques, qui soit bon conducteur thermique, qui minimise les effets différentiels de dilatation et de contraction pouvant survenir suite à des variations de températures dans l'interposeur lui-même ou entre l'interposeur et les circuits auxquels celui-ci est connecté, et qui peut, le cas échéant, être souple et/ou être fabriqué à l'aide de techniques à bas coût.

A cet effet, l'invention a pour objet un dispositif d'interface comprenant une couche de matériau traversée de part en part par des électrodes métalliques destinées à connecter électriquement deux circuits électroniques.

Selon l'invention :
▪ la couche de matériau comprend une couche de graphène ayant un coefficient d'expansion thermique négatif ; et
▪ les électrodes comprennent chacune :
   ∘ un élément central électriquement conducteur réalisé dans l'épaisseur de la couche de graphène ; et
   ∘ une couche périphérique électriquement isolante, intercalée entre l'élément central et la couche de graphène.

Par couche de graphène, on entend une couche constituée sensiblement uniquement de graphène. Comme cela est connu, le graphène est un cristal bidimensionnel de carbone. Si du graphène se trouve à l'état naturel dans du graphite, le graphène est différent du graphite qui présente une structure cristalline différente. Le graphène présente ainsi des propriétés différentes du graphite. Alors que le graphite a un coefficient d'expansion thermique positif, le graphène a au contraire un coefficient d'expansion thermique négatif.

En d'autres termes, le graphène est un matériau bon conducteur thermique qui peut être réalisé sous la forme de couche munie de trous traversants à l'aide de techniques à bas coût, par exemple par sérigraphie.

En outre, en raison de sa nature cristalline en 2D (deux dimensions), la couche de graphène peut être formée sur un substrat souple, notamment en plastique tel que le PEN (polyéthylène naphtalate) et le PET (polyéthylène téréphtalate).

Enfin, le graphène est un matériau à coefficient d'expansion thermique négatif alors que le métal constitutif des électrodes présente un coefficient d'expansion thermique positif. Ainsi, le graphène se contracte alors que les électrodes se dilatent, évitant ainsi tout risque de décollement des électrodes. De plus, les circuits interconnectés par l'interposeur présentent des coefficients d'expansion thermique positifs. Ainsi, lorsque ces circuits subissent des dilations ou des contractions différentes, le graphène compense cette différence en maintenant les circuits en place.

Selon un mode de réalisation, l'élément central est constitué de cuivre, et la couche périphérique est constituée de monoxyde de cuivre. Le cuivre présente une faible résistance électrique et ne présente pas de propriété magnétique, et ne perturbe donc pas le fonctionnement des circuits connectés à l'interposeur.

L'invention a également pour objet un procédé de fabrication d'un dispositif d'interface comprenant une couche de matériau traversée de part en part par des électrodes métalliques destinées à connecter électriquement deux circuits électroniques.

Selon l'invention, le procédé comprend :
▪ la réalisation d'une couche en graphène, ayant un coefficient d'expansion thermique négatif, comprenant des trous traversant de part en part celle-ci aux emplacements prévus pour les électrodes ; et
▪ le remplissage des trous par des électrodes comprenant chacune :
   ∘ un élément central électriquement conducteur, réalisé dans l'épaisseur de la couche de graphène ; et
   ∘ une couche périphérique électriquement isolante, intercalée entre l'élément central et la couche de graphène.

Selon un mode de réalisation, chaque électrode est réalisée :
▪ en formant, sur une face de la couche de graphène et dans l'emprise du trou de l'électrode, une couronne de matériau absorbant ou réfléchissant un rayonnement ultraviolet transformant par recuit un oxyde de cuivre en cuivre;
▪ en déposant de l'oxyde de cuivre dans le trou ; et
▪ en appliquant au travers de la couronne, ledit rayonnement ultraviolet de manière à transformer la portion d'oxyde de cuivre exposée audit rayonnement en un élément central en cuivre.

En d'autres termes, la réduction de l'oxyde de cuivre en cuivre par un recuit UV ne nécessite aucun chauffage global du dispositif. En outre, l'application du recuit UV n'induit pas, au niveau des électrodes, d'élévation importante de la température, et permet donc de déposer le cas échéant la couche de graphène sur un support en plastique.

En outre, l'utilisation du recuit ultraviolet, combiné avec un masque sous forme de couronne réalisé sur une entrée d'un trou, permet de réaliser en une seule étape l'élément central conducteur et la couche d'isolant électrique périphérique isolant l'élément central du graphène qui est un matériau conducteur de l'électricité.

Notamment, la couronne est constituée d'or, de titane ou d'argent, et son épaisseur est avantageusement supérieure à 30 nanomètres.

En outre, le recuit ultraviolet consiste en une impulsion photonique d'une durée comprise entre 0,5 milliseconde et 2 millisecondes, et de fluence comprise entre 200 Joules et 1500 Joules, notamment une durée de 1,5 milliseconde et une fluence de 1400 Joules. De telles valeurs permettent ainsi de réduire du monoxyde de cuivre (CuO) en cuivre (Cu).

Par exemple, le rayonnement UV est émis par une lampe flash de référence « XENON® PulseForge » de la société Xénon Corporation Xenon, disposée à 5 centimètres de la couche de graphène.

### BREVE DESCRIPTION DES FIGURES

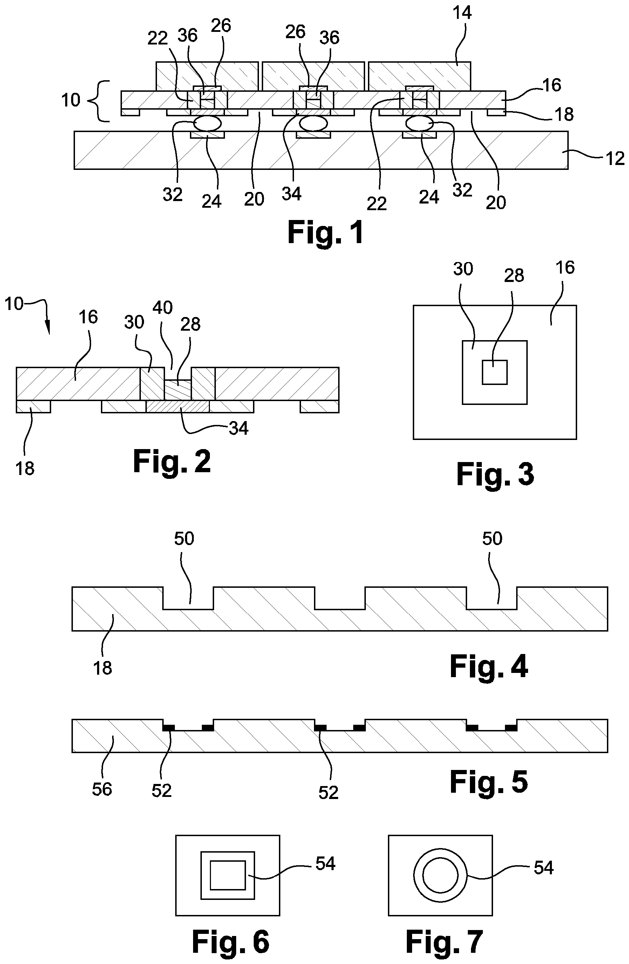

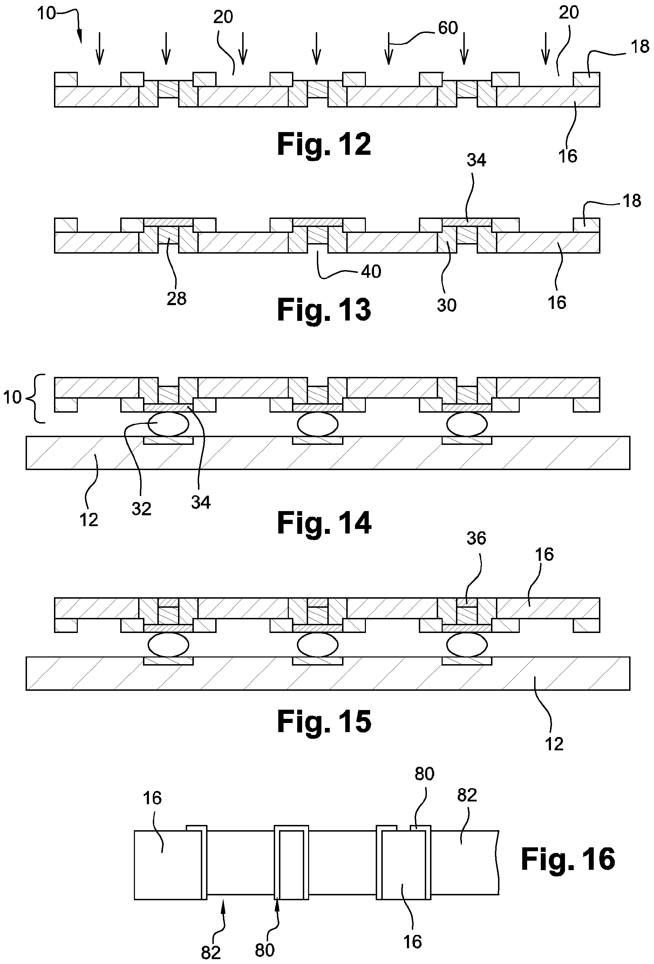

L'invention sera mieux comprise à la lecture de la description qui suit, donnée uniquement à titre d'exemple, et réalisée en relation avec les dessins annexés, dans lesquels des références identiques désignent des éléments identiques ou analogues, et dans lesquels:
▪ la figure 1 est une figure schématique en coupe d'un dispositif conforme à l'invention ;
▪ la figure 2 est une vue de détail de la figure 1, illustrant une électrode d'un interposeur selon l'invention ;
▪ la figure 3 est une vue de détail de dessus, illustrant une électrode d'un interposeur selon l'invention ;
▪ les figures 4 à 15 sont des vues schématiques illustrant un procédé de fabrication d'un interposeur et d'un circuit conforme à l'invention ; et
▪ la figure 16 est une vue schématique en coupe illustrant une variante d'interposeur conforme à l'invention.

### DESCRIPTION DETAILLEE DE L'INVENTION

En se référant à la figure schématique en coupe 1, un interposeur selon l'invention **10** réalise l'interconnexion électrique et mécanique entre un premier et second circuit micro électroniques **12**, **14**. Le premier circuit **12** est par exemple une carte de circuit imprimée, ou « PCB », servant de support à l'ensemble et comportant des pistes conductrices pour l'alimentation électrique et/ou la communication du second circuit **14.** Le second circuit **14** est, quant à lui, par exemple constitué d'une ou plusieurs puces électroniques, alimentées électriquement par le premier circuit **12** ou travers de l'interposeur **10.**

L'interposeur **10** comporte une couche de graphène **16**, optionnellement déposée sur une couche en matériau flexible **18**, notamment un plastique à bas coût, tel que du polyéthylène naphtalate (PEN), du polyéthylène téréphatalate (PET) ou du polyimide (PI), dans laquelle sont ménagées des ouvertures d'évacuation thermique **20.**

L'interposeur **10** comporte également des électrodes conductrices traversantes pleines **22,** réalisant l'interconnexion électrique entre des plages, pistes et/ou éléments de connexion **24**, **26** des premier et second circuits **12**, **14**.

Chacune des électrodes **22** comporte un cœur métallique **28** et une couche périphérique **30** en matériau électrique isolant, intercalée entre la couche de graphène **16** et le cœur **22** afin d'isoler électriquement le cœur **22** des électrodes du graphène qui est un matériau électriquement conducteur.

La liaison éléctro-mécanique entre l'interposeur **10** et les circuits **12**, **14** peut être réalisée par tout moyen connu en soi de l'état de la technique. Selon une première variante, illustrée par l'interconnexion de l'interposeur **10** avec le premier circuit **12**, l'interconnexion est réalisée par des billes ou plots conducteurs **32.** De la colle **34** est déposée sur les électrodes **22** et le premier circuit **12**, muni des éléments conducteurs **32**, est reporté sur l'interposeur **10** de manière à poser les éléments **32** sur les points de colle **34.**

Selon une deuxième variante, l'inteconnexion est réalisée par des billes de soudure **32.** Les électrodes **22** sont recouvertes sur leur face en regard du premier circuit **12** d'une plage **34** en métal mouillable par un matériau de soudure, les plages **26** du premier circuit **12** sont également recouvertes ou constituées d'un tel métal, et l'interposeur **10** et le circuit **12** sont alors connectés électriquement et mécaniquement par fusion des billes de soudure **32**, par exemple à l'aide d'une technique d'hybridation de type « *flip chip* ».

Selon une troisième variante, illustrée par l'interconnexion de l'interposeur **10** avec le second circuit **14**, l'interconnexion est réalisée au moyen d'une colle conductrice **36**, notamment un mélange de colle époxy avec des particules métalliques, comme de l'argent par exemple. De la colle est à cet effet déposée sur les éléments centraux des électrodes **22**, et le second circuit **14** est reporté sur l'interposeur **10** de manière à poser les plages de connexion **26** sur les points de colle **36.**

De manière avantageuse, l'agencement des éléments d'interconnexion entre l'interposeur **10** et les deux circuits **12**, **14** est réalisé pour optimiser l'évacuation thermique de la chaleur produite par ces derniers. Notamment, un circuit susceptible de produire beaucoup de la chaleur, comme par exemple le second circuit **14**, est avantageusement disposé au contact de la couche de graphène **16**, afin d'avoir une surface d'échange thermique maximale avec celle-ci. Le graphène est en effet un bon conducteur thermique, ayant une conductivité thermique proche de 5000 W/m.K, et permet donc une évacuation importante de la chaleur.

Dans le cadre d'une interconnexion par une colle conductrice **36**, une cavité **40** est par exemple réalisée dans l'élément central **28** de chacune des électrodes **22**, et la colle est déposée dans les cavités **40** afin d'éviter la formation de plots de colle protubérant s'opposant au contact de la couche de graphène **16** avec le second circuit **14**, la colle définissant de manière avantageuse une surface de collage qui affleure uniquement à la surface de la couche **16.** En outre, les cavités **40** permettent d'augmenter la surface de contact entre la colle **36** et l'interposeur **10**, ce qui accroit la tenue mécanique de l'ensemble.

De manière avantageuse, un circuit peut également être espacé de l'interposeur **10**, comme par exemple le premier circuit **12** en raison de la présence des billes de soudure **32**, afin d'optimiser également l'évacuation thermique. Notamment, dans la configuration illustrée à la figure 1, le premier circuit **12** peut être une carte d'alimentation électrique constituée en majorité d'un matériau mauvais conducteur thermique. La présence de la lame d'air ainsi définie entre l'interposeur **10** et le premier circuit **12** permet d'évacuer plus efficacement la chaleur produite par le second circuit **14** ménagé au contact de la couche de graphène **16.** Le choix d'un contact avec la couche de graphène ou d'une lame d'air ou le vide d'un circuit dépend par exemple de l'application et/ou des contraintes de fabrication et de fonctionnement du système.

Par ailleurs, le graphène est un matériau ayant un coefficient d'expansion thermique négatif, c'est-à-dire un matériau qui se contracte avec une élévation de la température et que se dilate avec une diminution de la température. Or, les métaux ont des coefficients d'expansion thermique positifs de sorte que sous l'effet d'une élévation de température les électrodes se dilatent. Comme par ailleurs, le graphène se contracte, les électrodes restent donc toujours au contact de la couche **16**, de sorte qu'il n'y a pas de phénomène de décollement.

En outre, les matériaux constitutifs des circuits microélectroniques présentent également usuellement un coefficient d'expansion thermique positif. Aussi, le graphène oppose une résistance aux variations géométriques des circuits **12**, **14**. Par exemple, lorsque les premier et second circuits subissent des élévations différentes de température, et donc tentent de se dilater de manière différente, la couche de graphène subit au contraire une contraction qui s'oppose à la dilatation des circuits et réduit donc la différence de dilatation résultante. Dans une variante avantageuse, les deux circuits **12**, **14** sont chacun disposés au contact de la couche de graphène **16**, par exemple au moyen de colle comme décrit précédemment, de manière à maximiser la force de rappel exercée par la couche de graphène **16.**

Il va à présent être décrit un procédé de réalisation d'un interposeur selon l'invention ainsi qu'un procédé d'empilement dudit interposeur avec les premier et second circuits tels que décrits précédemment.

Le procédé débute par la formation d'un substrat flexible transparent au rayonnement ultraviolet **18.** Notamment, le substrat est constitué de couche de plastique à bas coût, par exemple en PEN, PET ou PI et présente une épaisseur comprise entre 25 micromètres et 50 micromètres. Des cavités **50** sont alors réalisées dans une face du substrat **18** aux emplacements souhaitées pour les électrodes **22** de l'interposeur **10**, par exemple au moyen d'une photolithographie mettant en œuvre une gravure par du méthyle benzoate, ou par une gravure au plasma d'oxygène (O₂) et/ou d'héxafluorure de soufre (SF₆). Les cavités **50** sont par exemple de section circulaire ou carrée, de largeur comprise entre 50 micromètres et 100 micromètres, et de profondeur comprise entre 1 micromètre et 5 micromètres (figure 4 en coupe).

Le procédé se poursuit alors par la formation d'une couronne **52** en matériau absorbant ou réfléchissant le rayonnement ultraviolet, dans le fond de chaque cavité **50** et au contact du bord de la cavité. Par exemple, la couronne **52** est constituée d'or, de platine, d'argent, ou en un matériau organique bloquant le rayonnement ultraviolet, comme le pyrène par exemple (figure 5 en coupe et figures 6 et 7 de dessus illustrant respectivement une couronne de section carrée et une couronne de section circulaire).

Les couronnes **52** sont par exemple réalisées au moyen d'un dépôt physique en phase vapeur au travers d'un masque, ou pleine plaque suivi d'une gravure par voie humide ou par plasma excimère, ou au moyen d'une sérigraphie ou d'une impression jet d'encre.

L'épaisseur de la couronne **52** est choisie très inférieure à la profondeur des cavités **50**, et de préférence comprise entre 20 nanomètres et 50 nanomètres, et avantageusement une épaisseur de 30 nanomètres pour l'or, cette épaisseur étant suffisante pour bloquer efficacement le rayonnement ultraviolet décrit ci-après. Le diamètre ou les dimensions internes des couronnes **52** sont choisies en fonction des dimensions souhaitées pour les éléments centraux des électrodes **22.** La largueur des couronnes **52** est quant à elle choisie en fonction de la largueur souhaitée pour la couche isolante **30** séparant le cœur **22** des électrodes de la couche de graphène **16**, et est comprise entre 5 micromètres à quelques dizaines de micromètres lorsque cette couche est constituée de CuO.

Dans une étape suivante, la surface **56** subit un traitement de surface améliorant l'adhérence d'une couche de graphène ultérieurement déposée sur celle-ci. Notamment, ce traitement consiste en l'application d'un plasma d'ozone (O₃) combinée avec l'application d'un rayonnement UV pendant une durée comprise entre 2 minutes et 20 minutes, suivie de l'application d'un plasma d'oxygène pendant plusieurs dizaines de secondes, notamment 60 secondes. Un tel traitement de surface a pour effet d'augmenter la rugosité de la surface et d'éliminer d'éventuels résidus organiques présents sur la surface **56.**

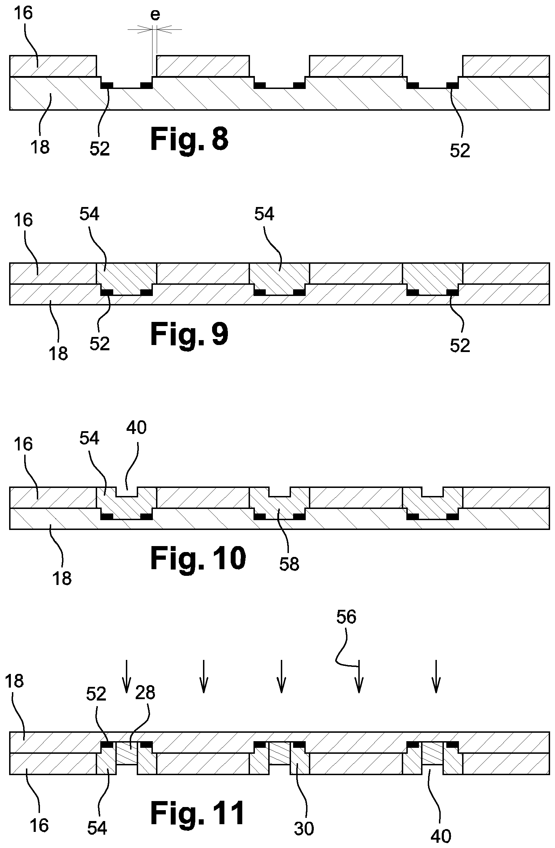

Le procédé se poursuit alors par le dépôt d'une couche de graphène **16** sur la surface **56** du substrat **18** en laissant les cavités **50** libres, par exemple une couche d'épaisseur comprise entre 25 micromètres et 100 micromètres (figure 8 en coupe).

Avantageusement, le graphène est déposé à l'aide d'une technique à bas coût, notamment par sérigraphie utilisant une encre de graphène ayant un solvant du type cyclohexane, ce qui permet par exemple d'obtenir une couche de graphène constituée d'un empilement de nan-feuillets de graphène, chaque nano-feuillet ayant une épaisseur de quelques couches atomiques d'épaisseur. En variante, la couche de graphène est obtenue par une technique de dépôt par jet d'encre ou par dépôt en phase vapeur. De préférence, le graphène est déposé en présentant un retrait par rapport aux bords des cavités **50** d'une largeur « *e* » comprise entre 5 micromètres à 10 micromètres pour garantir que du graphène n'est pas déposé dans les cavités **50**, et notamment sur les couronnes **52**, et/ou la viscosité de l'encre de graphène, et/ou la mouillabilité de la surface **56** est adaptée pour que l'étalement de l'encre avant son séchage complet ne conduit pas celle-ci à s'écouler dans les cavités **50.**

Une fois l'encre de graphène déposée, un recuit de température comprise entre 100°C et 130°C est appliqué pendant une durée supérieure à 10 minutes, notamment une durée comprise entre 10 minutes et 30 minutes, afin d'évaporer les solvants de l'encre et ainsi solidifier la couche de graphène **16.**

Lors d'une étape suivante, les cavités **50** sont alors remplies totalement ou partiellement, par exemple sur une épaisseur comprise entre 20 micromètres et 100 micromètres, de monoxyde de cuivre (CuO) **54** (figure 9 en coupe), par exemple au moyen d'une sérigraphie ou impression jet d'encre déposant une encre de CuO à base d'eau, et de préférence par pulvérisation de cette encre lorsque de faibles épaisseurs de dépôt sont recherchées. Par exemple, l'encre de CuO est une encre de référence « Metalon® ICI-020 » ou « Metalon® ICI-021 » de la société Novacentrix, Texas, USA.

Un recuit de température comprise entre 100°C et 130°C est alors appliqué pendant 10 à 30 minutes pour sécher l'encre et ainsi solidifier le CuO **54.**

Le procédé se poursuit alors par une gravure localisée au centre des éléments en CuO **54** afin de réaliser des cavités **40** recevant ultérieurement de la colle, comme décrit précédemment (figure 10 en coupe).

Le procédé se poursuit alors par l'application d'une impulsion photonique dans la gamme de longueurs d'onde ultraviolettes **56**, notamment de longueur d'onde comprise entre 200 nanomètres et 700 nanomètres, au travers du substrat **18** à la verticale de chaque plot en CuO **54**, l'impulsion étant par exemple appliquée sur l'ensemble de la surface du substrat **18** (figure 11 en coupe).

L'impulsion ultraviolette **56** a une durée comprise entre 0,5 milliseconde et 2 millisecondes, et une énergie comprise entre 200 Joules et 1400 Joules, de manière avantageuse une durée de 1,5 milliseconde et une énergie de 1400 Joules. Ces valeurs d'énergie permettent de transformer le CuO en Cu par la face arrière du substrat plastique de PEN ou PET. L'impulsion **56** est par exemple produite par une lampe flash UV, notamment une lampe flash de référence « XENON® PulseForge » de la société Xénon Corporation. De manière avantageuse, la distance séparant la lampe du composant **10** est comprise entre 3 centimètres et 7 centimètres, et plus particulièrement 5 centimètres. Cette distance étant la distance à laquelle le système optique de la lampe à Xénon focalise l'impulsion lumineuse envoyée, c'est-à-dire la distance du maximum d'énergie.

L'impulsion UV **56** traverse alors le substrat **18**, est incidente sur la portion d'oxyde de cuivre **58** comprise dans chaque couronne de matériau absorbant **52.** Parallèlement, la couronne de matériau absorbant ou réfléchissant **52** bloque au moins une partie de l'impulsion ultraviolette et empêche ainsi, au moins partiellement, que cette impulsion atteigne la portion d'oxyde de cuivre présente sous la couronne **52.** L'impulsion ultraviolette **62** induit alors un recuit de l'oxyde de cuivre présente dans les couronnes **52**, qui subit une réduction en cuivre (Cu), formant ainsi les cœurs conducteur **28** de cuivre des électrodes **22** de l'interposeur **10.** Ainsi l'oxyde de cuivre, qui est mauvais conducteur de l'électricité avec une résistance carré de l'ordre de 10⁶ Ω/□, est réduit en cuivre, qui est bon conducteur de l'électricité ayant une résistance carré égale à 60 mΩ/□.

En outre, le recuit est réalisé localement, c'est-à-dire dire au niveau des plots **54**, et non pas sur l'ensemble du substrat **18**, mais en outre le recuit induit une température inférieure à 100 °C, et donc à une température inférieure à la température de transition vitreuse du plastique constitutif du substrat **18.**

Dans une étape suivante, des ouvertures sont ménagées dans le substrat **18** pour dégager les plots **54.** Optionnellement, des ouvertures **20** supplémentaires sont ménagées dans le substrat **18** jusqu'à la couche de graphène **16** de manière à augmenter l'évacuation des flux thermiques par cette dernière (figure 12 en coupe). Les ouvertures dans le substrat **18** sont par exemple réalisées par une gravure laser excimère ou UV **60.** De préférence, les ouvertures ménagées pour dégager les plots **54** forment des couronnes pour la réception ultérieure de volumes de colle, ce qui ainsi d'éviter l'étalement de ceux-ci et/ou leur contact avec la couche de graphène **16.**

En variante, l'ensemble du substrat **18** est retiré, ce qui permet une évacuation maximale des flux thermiques.

De manière préférentielle, les couronnes **52** sont également retirées, par exemple en mettant en œuvre une gravure laser laser excimère ou UV, qui présentent l'avantage d'être sélective et de ne pas attaquer le graphène, le cuivre et le monoxyde du cuivre, la gravure s'arrêtant sur ces éléments.

Le procédé se poursuit alors par l'hybridation proprement dite de l'interposeur **10** venant d'être réalisé avec les premier et second circuits **12**, **14.** Notamment, des volumes de colle **34** sont déposés sur les faces des électrodes **22** opposées aux faces dans lesquelles sont ménagées les cavités **40**, par exemple un mélange de colle époxy avec des particules métalliques, notamment en Argent, du fabriquant Heraeus. Le dépôt est par exemple réalisé par sérigraphie au travers d'un masque ou par un bras robotisé qui dépose des points de colle uniquement aux emplacements souhaités (figure 13 en coupe). Parallèlement, le premier circuit **12** est muni de billes solides conductrices, ou « *stud bumps* », notamment en or.

Alors que la colle **34** n'est pas encore solidifiée, l'interposeur **10** et le premier circuit **12** sont hybridés de manière à mettre en contact les billes **32** avec les points de colle **34**, puis un recuit d'une température comprise entre 60°C et 90°C est appliqué pendant une durée comprise entre 5 minutes et 30 minutes afin de solidifier la colle (figure 14 en coupe).

Le procédé se poursuit alors par l'hybridation du second circuit **14** et de l'interposeur **10** en remplissant les cavités **40** ménagées dans les électrodes **22** par de la colle conductrice **36**, par exemple celle décrit ci-dessus (figure 15 en coupe), en reportant le second circuit **14** sur l'interposeur **10** de manière à mettre en contact les points de colle **36** avec les plages de connexion **26** du second composant **14**, puis en appliquant un recuit tel que précédemment décrit afin de solidifier l'ensemble (figure 1).

Il a été décrit un mode de réalisation dans lequel les électrodes **22** de l'interposeur sont obtenues en procédant à un flash UV partiel d'un plot de CuO afin de définir simultanément une couche isolante et un cœur conducteur pour chaque électrode.

D'autres types d'électrodes sont bien évidement possibles. Notamment, comme illustré à la figure 16, les bords des cavités présentes dans la couche de graphène **16** avant le remplissage de celles-ci par un matériau conducteur, peuvent être recouverts d'une couche isolante **80** puis un matériau conducteur, par exemple du cuivre, du titane ou du nickel peut alors être déposé dans les cavités de manière à former les éléments centraux conducteurs **82** des électrodes de l'interposeur. Par exemple, les couches isolantes **80** sont réalisées en déposant une couche de métal par pulvérisation sur les bords des cavités, puis en appliquant un plasma d'oxygène, qui oxyde le métal déposé et forme ainsi une couche d'oxyde métallique de conductivité électrique très élevée, et donc isolante.

Il a été décrit des interposeurs constitué d'une unique couche de graphène traversées par des connexions électriques. En variante, une couche de matériau conductrice ou isolante peut être déposée sur l'une et/ou l'autre face de la couche graphène, comme par exemple une fine couche métallique, notamment du Cuivre, de l'Or, ou du Titane, en évitant que ladite couche ne soit au contact des connexions traversantes pour éviter un court-circuit. Bien qu'une telle couche supplémentaire compense en partie le coefficient d'expansion négatif de la couche de graphène, cela permet la mise en œuvre de fonctions supplémentaires.

## Revendications

1. Dispositif d'interface (10) comprenant une couche de matériau (16) traversée de part en part par des électrodes métalliques (22) destinées à connecter électriquement deux circuits électroniques (12, 14), ***caractérisé*** :
▪ en ce que la couche de matériau (16) comprend une couche de graphène ayant un coefficient d'expansion thermique négatif ;
▪ et en ce que les électrodes (22) comprennent chacune :
**∘** un élément central (28) électriquement conducteur, réalisé dans l'épaisseur de la couche de graphène (16) ; et
∘ une couche périphérique (30) électriquement isolante, intercalée entre l'élément central (28) et la couche de graphène (16).

2. Dispositif d'interface selon la revendication 1, ***caractérisé* en ce que** l'élément central (28) est constitué de cuivre, et **en ce que** la couche périphérique (30) est constituée de monoxyde de cuivre.

3. Procédé de fabrication d'un dispositif d'interface (10) comprenant une couche de matériau (16) traversée de part en part par des électrodes métalliques (22) destinées à connecter électriquement deux circuits électroniques (12, 14), ***caractérisé* en ce qu'**il comprend :
▪ la réalisation d'une couche en graphène (16), ayant un coefficient d'expansion thermique négatif, comprenant des trous traversant de part en part celle-ci aux emplacements prévus pour les électrodes (22); et
▪ le remplissage des trous par des électrodes (22) comprenant chacune :
**∘** un élément central (28) électriquement conducteur, réalisé dans l'épaisseur de la couche de graphène (16) ; et
**∘** une couche périphérique (30) électriquement isolante, intercalée entre l'élément central (28) et la couche de graphène (16).

4. Procédé de fabrication d'un dispositif d'interface (10) selon la revendication 3, ***caractérisé* en ce que** chaque électrode (22) est réalisée :
▪ en formant, sur une face de la couche de graphène (16) et dans l'emprise du trou de l'électrode, une couronne (52) de matériau absorbant ou réfléchissant un rayonnement ultraviolet, transformant par recuit un oxyde de cuivre en cuivre;
▪ en déposant de l'oxyde de cuivre (54) dans le trou ; et
▪ en appliquant au travers de la couronne (52) ledit rayonnement ultraviolet (56) de manière à transformer la portion d'oxyde de cuivre exposée audit rayonnement en un élément central en cuivre.

5. Procédé de fabrication d'un dispositif d'interface (10) selon la revendication 4, ***caractérisé* en ce que** la couronne (52) est constituée d'or, de titane ou d'argent.

6. Procédé de fabrication d'un dispositif d'interface (10) selon la revendication 4 ou 5, ***caractérisé* en ce que** la couronne (52) a une épaisseur supérieure à 30 nanomètres.

7. Procédé de fabrication d'un dispositif d'interface (10) selon l'une des revendications 4 à 6, ***caractérisé* en ce que** le recuit ultraviolet consiste en une impulsion photonique d'une durée comprise entre 0,5 milliseconde et 2 millisecondes, et de fluence comprise entre 200 Joules et 1500 Joules, notamment une durée de 1,5 milliseconde et une fluence de 1400 Joules.

## Patentansprüche

1. Zwischenträger (10) mit einer Materialschicht (16), die quer von Metallelektroden (22) durchzogen ist, um zwei elektronische Schaltkreise (12, 14) elektrisch zu verbinden. ***dadurch gekennzeichnet***:
▪ dass die Materialschicht (16) eine Graphenschicht mit einem negativen Wärmeausdehnungskoeffizienten enthält;
▪ und dass die Elektroden (22) jeweils enthalten:
**∘** ein elektrisch leitendes zentrales Element (28), das in der Dicke der Graphenschicht (16) gebildet ist; und
**∘** eine elektrisch isolierende periphere Schicht (30), die zwischen dem zentralen Element (28) und der Graphenschicht (16) angeordnet ist.

2. Zwischenträger nach Anspruch 1, ***dadurch gekennzeichnet, dass*** das zentrale Element (28) aus Kupfer besteht und dass die periphere Schicht (30) aus Kupfermonoxid besteht.

3. Herstellungsverfahren für einen Zwischenträger (10) mit einer Materialschicht (16), die quer von Metallelektroden (22) durchzogen ist, um zwei elektronische Schaltkreise (12, 14) elektrisch zu verbinden, ***dadurch gekennzeichnet, dass*** es umfasst:
▪ die Herstellung einer Graphenschicht (16), mit einem negativen Wärmeausdehnungskoeffizienten, die an den Stellen, die für die Elektroden (22) vorgesehen sind, Löcher enthält, die quer durch sie hindurchführen; und
▪ das Einsetzen der Elektroden (22), in diese Löcher, wobei die Elektroden umfassen:
**∘** eine elektrisch isolierende periphere Schicht (30), die zwischen dem zentralen Element (28) und der Graphenschicht (16) ausgeführt ist; und
**∘** eine elektrisch isolierende periphere Schicht (30), die zwischen dem zentralen Element (28) und der Graphenschicht (16) angeordnet ist.

4. Herstellungsverfahren für einen Zwischenträger (10) nach Anspruch 3, ***dadurch gekennzeichnet, dass*** jede Elektrode (22) hergestellt wird,
▪ indem auf einer Seite der Graphenschicht (16) und innerhalb des Elektrodenlochs ein Kranz (52) aus einem Material hergestellt wird, das ultraviolette Strahlung absorbiert oder reflektiert und durch Glühen ein Kupferoxid in Kupfer umwandelt;
▪ indem Kupferoxid (54) im Loch abgeschieden wird; und
▪ indem durch den Kranz (52) diese ultraviolette Strahlung (56) angewandt wird, so dass die Menge Kupferoxid, die dieser Strahlung ausgesetzt ist, in ein zentrales Element aus Kupfer umgewandelt wird.

5. Herstellungsverfahren für einen Zwischenträger (10) nach Anspruch 4, ***dadurch gekennzeichnet, dass*** der Kranz (52) aus Gold, Titan oder Silber besteht.

6. Herstellungsverfahren für einen Zwischenträger (10) nach Anspruch 4 oder 5, ***dadurch gekennzeichnet, dass*** der Kranz (52) eine Dicke von über 30 Nanometern hat.

7. Herstellungsverfahren für einen Zwischenträger (10) nach einem der Ansprüche 4 bis 6, ***dadurch gekennzeichnet, dass*** das Ultraviolett- Glühen aus einem Photonenimpuls mit einer Dauer zwischen 0,5 Millisekunden und 2 Millisekunden besteht, mit einer Fluenz zwischen 200 Joules und 1500 Joules, vor allem eine Dauer von 1,5 Millisekunden und eine Fluenz von 1400 Joules.

## Claims

1. An interface device (10) comprising a layer of material (16) thoroughly crossed by metal electrodes (22) intended to electrically connect two electronic circuits (12, *14),* ***characterized:***
• **in that** the layer of material (16) comprises a graphene layer having a negative thermal expansion coefficient;
• and **in that** the electrodes (22) each comprise:
o a central electrically-conductive element (28) formed across the thickness of the graphene layer (16); and an electrically-insulating peripheral layer (30), interposed between the central element (28) and the graphene layer (16).

2. The interface device of claim 1, ***characterized* in that** the central element (28) is made of copper, and **in that** the peripheral layer (30) is made of copper monoxide.

3. A method of manufacturing an interface device (10) comprising a layer of material (16) thoroughly crossed by metal electrodes (22) intended to electrically connect two electronic circuits (12, 14), ***characterized* in that** it comprises:
• forming a graphene layer (16) having a negative thermal expansion coefficient, comprising holes thoroughly crossing it at the locations provided for the electrodes (22); and
• filling the holes with electrodes (22), each comprising:
o a central electrically-conductive element (28) formed across the thickness of the graphene layer (16); and
o an electrically-insulating peripheral layer (30), interposed between the central element (28) and the graphene layer (16).

4. The method of manufacturing an interface device (10) of claim 3, ***characterized* in that** each electrode (22) is formed:
▪ by forming, on a surface of the graphene layer (16) and in the area occupied by the electrode hole, a ring (52) of a material absorbing or reflecting an ultraviolet radiation converting by anneal a copper oxide to copper;
▪ by depositing the copper oxide (54) into the hole; and
▪ by applying through the ring (52) said ultraviolet radiation (56) to convert the copper oxide portion exposed to said radiation into a central copper element.

5. The method of manufacturing an interface device (10) of claim 4, ***characterized* in that** the ring (52) is made of gold, titanium, or silver.

6. The method of manufacturing an interface device (10) of claim 4 or 5, ***characterized* in that** the ring (52) has a thickness greater than 30 nanometers.

7. The method of manufacturing an interface device (10) of any of claims 4 to 6, ***characterized* in that** the ultraviolet anneal is achieved by a photonic pulse having a duration in the range from 0.5 millisecond to 2 milliseconds and having a fluence in the range from 200 Joules to 1,500 Joules, particularly a 1.5-millisecond duration and a 1,400 Joule fluence.
